# EUROPÄISCHE PATENTSCHRIFT

(11) **EP 1 929 515 B1**
(45) Veröffentlichungstag und Bekanntmachung des Hinweises auf die Patenterteilung: **22.06.2011**
(21) Anmeldenummer: 06791398.8
(22) Anmeldetag: 22.09.2006
(51) Int. Cl.: H01L 21/603, H01L 51/52

(54) **VERFAHREN ZUR VERBINDUNG VON SCHICHTEN**
METHOD FOR CONNECTING LAYERS
PROCEDE POUR RELIER DES COUCHES

(30) Priorität: 30.09.2005 DE 102005046942
(43) Veröffentlichungstag der Anmeldung: 11.06.2008
(73) Patentinhaber: OSRAM Opto Semiconductors GmbH, 93055 Regensburg (DE)
(72) Erfinder: GROLIER, Vincent, 93047 Regensburg (DE); PLÖSSL, Andreas, 93051 Regensburg (DE); RENNER, Marianne, 80469 München (DE)
(74) Vertreter: Epping - Hermann - Fischer
(86) Internationale Anmeldenummer: PCT/DE2006/001688
(87) Internationale Veröffentlichungsnummer: WO 2007/036208

(56) Entgegenhaltungen:
- EP-A2- 1 603 171
- EP-A2- 1 603 171
- WO-A1-2005/064697
- WO-A1-2005/064697
- JP-A- 2004 178 985
- US-A- 5 996 221
- US-A1- 2003 043 316
- US-A1- 2003 214 618
- US-A1- 2004 191 939
- US-A1- 2004 191 939
- C. H. TSAU ET AL.: "Fabrication of wafer-level thermocompression bonds" JOURNAL OF MICROELECTROMECHANICAL SYSTEMS, Bd. 11, Nr. 6, 1. Dezember 2002 (2002-12-01), Seiten 641-647, XP002415528 IEEE
- M.M.V. TAKLO ET AL.: "Strong, high-yield and low temperature thermocompression silicon wafer-level bonding with gold" JOURNAL OF MICROMECHANICAL ENGINEERING, Bd. 14, 13. April 2004 (2004-04-13), Seiten 884-890, XP002415529 IOP, UK

## Beschreibung

Die Erfindung betrifft ein Verfahren zur Herstellung eines Strahlung emittierenden Halbleiterbauelements.

Bei der Herstellung von Strahlung emittierenden Bauelementen, insbesondere Halbleiterbauelementen in Dünnschichttechnologie, und organischen Leuchtdioden, sogenannten OLEDs, spielt die Anwendung geeigneter Fügetechniken eine entscheidende Rolle.

Die Anwendung der Dünnschichttechnologie auf Strahlung emittierende Halbleiterbauelemente ist unter anderem geeignet bei der Herstellung von Leuchtdioden mit IR-, UV- oder sichtbarem Spektrum sowie von Laserdioden (vertical cavity surface emitting laser oder vertical external cavity surfaceemitting laser).

Dünnschicht-Leuchtdiodenchips sind beispielsweise in der US 6,878,563 B2, der WO 02/13281 A1 und der EP 0905797 A2 beschrieben.

Die Herstellung von Strahlung emittierenden Halbleiterbauelementen in Dünnschichttechnologie sieht vor, dass zunächst auf einem Epitaxiesubstrat eine gewünschte Halbleiterstruktur aufgebracht wird. Im Anschluss daran muss die Epitaxieschicht auf einen Trägerkörper (Ersatzsubstrat) transferiert werden. Beim Transfer wird die epitaxierte Halbleiterheterostruktur mit Hilfe einer Fügetechnik mit dem Ersatzsubstrat verbunden. Danach wird das Epitaxiesubstrat entfernt.

Neben der mechanischen Festigkeit der Fügetechnik spielen weitere Parameter eine entscheidende Rolle. Die optoelektronische Schicht muss meist elektrisch oder thermisch leitend mit dem Ersatzträger gekoppelt werden. Deshalb sind dabei metallische Verbindungen besonders geeignet.

Bisher wurden die Halbleiterheterostrukturen mit dem Ersatzsubstrat meist durch Löten (eutektisches Bonden) oder Kleben verbunden. Bevorzugt ist eine metallische Verbindung durch Löten, weil diese aufgrund ihrer elektrischen und thermischen Leitfähigkeit besser geeignet ist. Allerdings können Metallschmelzen, wie sie sich in Lötprozessen bilden, benachbarte funktionelle Metallschichten wie etwa Spiegelschichten oder elektrische Kontakte angreifen. Deshalb müssen geeignete Sperrschichten die Fügezone zuverlässig von funktionellen Schichten beziehungsweise funktionellen Zonen trennen. Die Verwendung solcher Sperrschichten ist allerdings nicht unkritisch. Sperrschichten können zu einer Entnetzung des Lotes und damit zu einem Haftungsverlust führen. Daher erfordert die Verwendung der Fügetechnik des Lötens meist aufwendige Schicht- und Materialkombinationen.

Die Anwendung von Fügetechniken bei der Herstellung von organischen Leuchtdioden hingegen bezieht sich auf die notwendige Verkapselung dieser Bauelemente. Organische Leuchtdioden weisen meist Materialien auf, die durch eine Verkapselung vor Umwelteinflüssen geschützt werden müssen. Dazu wird oft durch eine Fügetechnik eine Schicht mit einer anderen deckelartigen Schicht verbunden, wodurch die eigentliche organische Leuchtdiodenstruktur hermetisch zwischen den Schichten verkapselt wird.

Klebetechniken, wie sie oft bei der Herstellung von organischen Leuchtdioden verwendet werden, zeichnen sich durch einfache Verarbeitungsprozessschritte aus. Allerdings erreichen sie nicht in jedem Falle die gewünschte Dauerhaftigkeit beziehungsweise Dichtigkeit.

Die Druckschrift "Fabrication of Wafer-Level Thermocompression Bonds", Journal of Microelectromechanical Systems, Vol. 11, No. 6, Dezember 2002 von Tsau et al. betrifft ein Verfahren zur Verbindung von Materialien mittels Thermokompression.

In der Druckschrift "Strong, high-yield and low-temperature thermocompression silicon wafer-level bonding with gold", Journal of Micromechanics and Microengineering, Vol. 14, Seiten 884 bis 890, veröffentlicht 2004, von Taklo et al. ist ein Verfahren zur Verbindung von Materialien mittels Thermokompression angegeben.

Eine reflektive Anzeigeeinrichtung mit drei gestapelten Ebenen ist in der Druckschrift US 2003/0043316 A1 offenbart.

In der Druckschrift US 5,996,221 ist eine Methode zum Verbinden von Strukturen mittels Thermokompression beschrieben.

Die Druckschrift JP 2004-178985 betrifft eine Herstellungsmethode für ein organisches, elektrolumineszentes Bauteil.

Eine Flüssigkristallanzeige und eine Herstellungsmethode für eine solche sind in der Druckschrift US 2003/0214618 A1 offenbart.

In der Druckschrift WO 2005/064697 A1 ist eine Leuchtdiode und eine Herstellungsmethode hierfür beschrieben.

Die Druckschrift EP 1 603 171 A2 betrifft ein III-Nitrid-Leuchtbauteil, bei dem ein Aufwachssubstrat entfernt ist.

Ein Licht emittierendes Halbleiterbauteil und eine Herstellungsmethode hierfür ist in der Druckschrift US 2004/0191939 A1 angegeben.

Der vorliegenden Erfindung liegt die Aufgabe zugrunde, auf einfache und kostengünstige Art und Weise eine Möglichkeit zur Verbesserung der Verbindung von Schichten bei der Herstellung eines Strahlung emittierenden Halbleiterbauteils anzugeben.

Die Erfindung löst die Aufgabe mit den Merkmalen des unabhängigen Patentanspruchs.

Vorteilhafte Ausführungen und Weiterbildungen der Erfindung sind Gegenstand der abhängigen Patentansprüche.

Das beanspruchte Verfahren umfasst eine Fügetechnik bzw. Verbindungstechnik, mit der eine metallische Verbindung hergestellt wird. Durch die Verwendung eines Thermokompressionsverfahrens kann die metallische Verbindung unter Vermeidung einer Metallschmelze hergestellt werden. Insbesondere tritt keine transiente Flüssigphase der zu verbindenden Metallschichten auf. Daraus resultieren ein vereinfachter Schichtaufbau, ein kostengünstiges Herstellungsverfahren und ein genau definierbarer Füge- bzw. Verbindungsbereich.

Bei organischen Leuchtdioden lässt sich durch eine Abwandlung des beanspruchten Verfahrens eine hermetische dauerhafte Kapselung der Bauteile erreichen. Zusätzlich kann dort ein innerhalb der Kapselung vorhandenes, nicht verdampfbares Gettermaterial aktiviert werden.

Bei der Herstellung von Strahlung emittierenden Dünnschicht-Halbleiterbauelementen ist vorgesehen, ein Halbleitermaterial und ein Ersatzsubstrat durch mindestens eine Goldschicht mit dem beanspruchten Verfahren mittels Thermokompression zu verbinden (Thermokompressionsverbindung). Da das Halbleitermaterial mittels der Goldschicht elektrisch beziehungsweise thermisch an das Ersatzsubstrat gekoppelt werden soll, weist zumindest einer der beiden Verbindungspartner eine der Fügezone zugewandte elektrische Kontaktfläche aus. Sowohl das Halbleitermaterial als auch das Ersatzsubstrat können an der Oberfläche, die der Fügezone zugewandt ist, weitere funktionelle Schichten wie Spiegelschichten, Barriereschichten, Sperrschichten und/oder Haftvermittlerschichten aufweisen.

Dem Substrat, beziehungsweise den darauf aufgeordneten Schichten, ist ebenso wie dem Halbleitermaterial und den darauf angeordneten Schichten in Richtung des Füge- bzw. Verbindungsbereichs jeweils eine Goldschicht nachgeordnet. Diese beiden Goldschichten werden in Kontakt gebracht und mittels einer Thermokompression mit vorgegebenen Parametern zu einer gemeinsamen Fügeschicht gefügt. Die gemeinsame Fügeschicht aus Gold weist vorteilhafterweise eine Gesamtdicke zwischen 100 nm und 5 µm auf. Bevorzugte Ausführungsformen der Erfindung weisen für prozessierte Wafer Gesamtdicken zwischen 500 nm und 2,5 µm auf. Allgemein können die beiden einzelnen Goldschichten vor dem Fügeschritt auch eine asymmetrische Dickenverteilung aufweisen. Das heißt, es können Goldschichten unterschiedlicher Dicke zu einer gemeinsamen Verbindungsschicht gefügt werden.

Die untere bzw. obere Schichtdicke definiert sich dadurch, dass eine flächige gemeinsame Verbindungsschicht hergestellt werden kann. Die obere Schichtdicke definiert sich zusätzlich technisch-wirtschaftlich, weil zu dicke Schichten nicht notwendig, aber teuer sind.

Bei der Verbindung hochglatter Oberflächen, wie beispielsweise unprozessierten Siliziumwafern, kann auch bereits eine einseitig aufgebrachte Goldschicht mit einer Dicke von unterhalb 10 nm ausreichen, um eine metallische Verbindung mit einer weiteren Goldschicht auf dem anderen Verbindungspartner zu erzielen.

Der Fügeschritt läuft in einem Temperaturbereich oberhalb von 200 °C ab. Als obere Temperaturbereichsgrenze wird 500 °C angesehen. Zweckmäßige Temperaturbereiche ergeben sich unter anderem aus den Zusammensetzungen der Schichtfolgen der einzelnen Verbindungspartner. Bei Galliumindiumnitridbasierten (GaInN) Strahlung emittierenden Dünnschichtfilmchips liegt ein zweckmäßiger Temperaturbereich cirka zwischen 350 °C und 400 °C. Bei Aluminiumgalliumindiumphosphid-basierten (AlGaInP) Strahlung emittierenden Dünnschichtfilmchips ist bevorzugt ein Temperaturbereich zwischen 350 °C und 500 °C zweckmäßig.

Diese Temperaturen sollten dabei zwischen 10 Sekunden und 10 Minuten auf die Verbindungspartner einwirken. Kürzere Zeiten vermögen meist keine ausreichende Verbindung herzustellen, und längere Einwirkzeiten können Beschädigungen sowohl der Halbleiterheterostruktur als auch der weiteren funktionellen Schichten verursachen. Zusätzlich bewirken zu lange Einwirkzeiten höhere Zykluszeiten und damit eine niedrigere Produktivität bei der Herstellung.

Der bei der Thermokompression aufgewendete Druck, mit welchem die beiden Verbindungspartner verpresst werden, liegt zwischen 1 x 10⁵ Pascal und 2 x 10⁷ Pascal. Bei prozessierten Wafern mit einem Durchmesser von 100 mm und mit einer strukturbedingten Kontaktfläche von 50% sollte vorteilhafterweise in etwa eine Kraft zwischen 1.000 und 100.000 Newton aufgewendet werden.

Eine weitere vorteilhafte Ausführungsform der Erfindung sieht vor, dass zwischen der Goldschicht und dem Halbleitermaterial beziehungsweise zwischen der Goldschicht und dem Ersatzsubstrat jeweils mindestens eine funktionelle Schicht aus Haftvermittlerschichten, Spiegelschichten, Kontaktschichten und/oder Pufferschichten angeordnet ist.

Dabei dienen Haftvermittlerschichten insbesondere dazu, die vor dem Fügeprozess aufgebrachte Goldschicht fest und gleichmäßig mit dem Ersatzsubstrat beziehungsweise dem Halbleitermaterial oder weiteren funktionellen Schichten zu verbinden.

Spiegelschichten erhöhen bei der Herstellung von Strahlung emittierenden Halbleiterbauelementen insbesondere die Lichtauskopplung an der der Spiegelschicht gegenüber liegenden Lichtauskoppelfläche.

Sperrschichten dienen insbesondere dazu, einen Ionentransport über die Schichten während des Thermokompressionsverfahrens zu verhindern oder zu verringern.

Kontaktschichten dienen insbesondere dazu, die elektrische oder thermische Kontaktierung der unterschiedlichen Schichtfolgen zu verbessern; Pufferschichten sind geeignet, unterschiedliche Gitterstrukturen (unterschiedliche Gitterkonstanten) einzelner Schichten der Schichtfolgen aneinander anzupassen.

Die Erfindung sieht vor, dass das Thermokompressionsverfahren nicht nur für die Verbindung zweier Goldschichten zu einer gemeinsamen Fügezone benutzt wird, sondern dass anstelle einer einfachen Goldschicht ein mehrschichtiger Aufbau aus jeweils einer Goldschicht und einer Aluminiumschicht mit einer dazwischen angeordneten Sperrschicht verwendet wird. Dadurch können gleichzeitig die Duktilität des Aluminiums sowie das inerte Verhalten der Goldschicht genutzt werden. Die Verformbarkeit des Aluminiums hilft bei der Herstellung einer stoffschlüssigen Verbindung der Oberflächen, während das inerte Verhalten von Gold bei der Verbindung von großen Flächen den Einsatz von Ultraschallschweißvorgängen oder Reibbewegungen erübrigt. Zusätzlich ermöglicht der Einsatz von Aluminiumschichten eine weitere Kostenreduktion. Die Sperrschicht, z.B. aus Wolfram (W) oder Titanwolfram (TiW), verhindert die Bildung unerwünschter intermetallischer Phasen von Gold und Aluminium, die oft zu als "Purpurpest" bezeichneten Zuverlässigkeitsrisiken führen.

Eine weitere vorteilhafte Ausführungsform der Erfindung sieht vor, dass das Thermokompressionsverfahren frei von Verfahrensschritten wie Reibbewegungen oder Ultraschallschweißvorgängen ist. In dieser vorteilhaften Ausführungsform der Erfindung werden die Halbleiterschichten, beziehungsweise das Ersatzsubstrat, geringeren mechanischen Belastungen ausgesetzt. Dadurch kann die Halbleiterschichtenfolge besser vor Zerstörung geschützt werden. Die Fügetechnik beschränkt sich somit weitgehend auf die Ausübung von Druck und die Einwirkung von erhöhten Temperaturen.

Ein Bauelement, das nach einem beschriebenen Verfahren hergestellt ist, weist dadurch einen einfacheren Schichtaufbau auf und wird somit im allgemeinem auch kostengünstiger hergestellt. Zusätzlich weisen derartige Bauelemente im Fügebereich meist einen geringeren elektrischen Widerstand und gleichzeitig eine höhere thermische Leitfähigkeit auf. Da bei erfindungsgemäßen Bauelementen keine Metallschmelzen auftreten, wie sie bei Bauelementen entstehen, bei denen der Substrattransfer durch Löten erfolgt, werden benachbarte Metallschichten wie etwaige Spiegelschichten oder elektrische Kontakte vor Beschädigung geschützt.

Mit einem erfindungsgemäßen Verfahren können auch ganze Wafer prozessiert werden. Die daraus entstehenden Halbzeuge weisen bezüglich der Fügezone ähnliche Vorteile auf wie sie bereits für erfindungsgemäß hergestellte Bauelemente beschrieben wurden.

Eine Abwandlung der Erfindung umfasst auch die Verkapselung von organischen Leuchtdioden (OLEDs). Im Inneren dieser organischen Leuchtdioden findet sich im allgemeinen ein mehrschichtiger Aufbau - die sogenannte OLED-Struktur. Meist sind dort zwischen zwei Kontaktschichten der Anode und der Kathode Schichten aus Strahlung emittierenden Polymeren oder Strahlung emittierenden Kleinmolekülen sowie Schichten aus elektronenlochleitenden Polymeren oder elektronenlochleitenden Kleinmolekülen angeordnet. Diese Schichtfolgen müssen hermetisch verkapselt werden, insbesondere zum Schutz vor Umwelteinflüssen.

Insbesondere organische Polymere, aber auch die Kontaktschichten von OLEDs, sind anfällig gegenüber der Einwirkung von atmosphärischen Gasen und Feuchtigkeit. Andererseits können die Kontaktschichten der OLEDs Erdalkalimetalle aufweisen, die wegen ihrer hoher Reaktivität vorteilhaft hermetisch gekapselt sein sollen. Dazu werden diese meist zwischen transparenten Deckschichten verkapselt. Gängige Materialien solcher Deckschichten sind Glas oder verschiedene Polymermaterialien bzw. Kunststoffe. Vorteilhafterweise sind diese transparent bezüglich der Emissionswellenlänge der Strahlung emittierenden Polymere beziehungsweise Kleinmoleküle.

Die Deckschichten werden bei einer Abwandlung des Verfahrens durch eine Thermokompression miteinander so verbunden (Thermokompressionsbonden), dass die gesamte Schichtabfolge der organischen Leuchtdiode verkapselt ist.

Eine weitere vorteilhafte Abwandlung des Verfahrens bei der Verkapselung von organischen Leuchtdioden entsteht, wenn mindestens eine der beiden Schichten, zwischen denen die organische Leuchtdiodenstruktur angeordnet ist, transparent bezüglich der Emissionswellenlängen der Strahlung emittierenden Kleinmoleküle beziehungsweise der Strahlung emittierenden Polymere ist.

Eine bevorzugte Abwandlung der Erfindung sieht vor, dass auf gegenüberliegenden Teilbereichen der beiden Deckschichten ein weiteres Material oder eine Verbindungschichtenfolge von Materialien aufgebracht ist, welche mittels Thermokompression miteinander verbunden werden. Diese Materialien weisen insbesondere Gold oder andere inerte Metalle auf. In weiteren Ausführungsformen werden allerdings auch Verbindungsschichtenfolgen verwendet, welche mehrere Schichten mit unterschiedlichen Materialien und Funktionen aufweisen.

Eine andere vorteilhafte Abwandlung der Erfindung sieht zur Verkapselung von organischen Leuchtdioden vor, dass die Verbindungsschichtenfolge mindestens eine Goldschicht, eine Aluminiumschicht, eine Isolatorschicht, eine Haftvermittlerschicht, eine Sperrschicht und/oder eine Kontaktschicht aufweist. Durch Isolatorschichten wird beispielsweise ein elektrischer Kurzschluss zwischen Anode und Kathode der organischen Leuchtdiode verhindert.

Bei Verwendung einer Schichtenabfolge aus Goldschichten, Aluminiumschichten und Sperrschichten kann die Duktilität des Aluminiums in Verbindung mit dem inerten Verhalten von Gold dazu genutzt werden, um eine feste Fügung mittels Thermokompression herzustellen, ohne dass dabei durch einen Kontakt zwischen Gold und Aluminium sogenannte Purpurpest auftritt. Haftvermittlerschichten bewirken insbesondere eine gleichmäßige Benetzung innerhalb der Schichtfolgen. Kontaktschichten ermöglichen eine Kontaktierung der innerhalb der Deckschichten und den Verbindungsschichtenfolgen verkapselten OLEDs.

Eine weitere vorteilhafte Abwandlung des Verfahrens sieht zur Verkapselung von OLEDs vor, dass zwischen zwei Deckschichten mehrere organische Leuchtdiodenstrukturen verkapselt werden und die verkapselten OLED-Strukturen danach vereinzelt werden. Diese Ausführungsform des Verfahrens ermöglicht die Herstellung einer Vielzahl von organischen Leuchtdioden auf kostengünstige und effiziente Art und Weise.

Eine organische Leuchtdiode (OLED), die nach einer Abwandlung des erfindungsgemäßen Verfahrens hergestellt ist, weist durch das eingesetzte Thermokompressionsverfahren eine verbesserte hermetische Kapselung auf und kann kostengünstig hergestellt werden. Durch die verbesserte hermetische Kapselung mittels einer metallischen Verbindung weist eine solche organische Leuchtdiode im allgemeinen eine längere Lebensdauer auf. Zusätzlich werden die organischen Leuchtdiodenstrukturen während des Fügeschrittes nur kurzfristig höheren Temperaturen ausgesetzt.

Weitere Vorteile und vorteilhafte Weiterbildungen der Erfindung ergeben sich im folgenden aus den in den Figuren der Zeichnung beschriebenen Ausführungsbeispielen. Es zeigen:
- Figur 1: einen bei der Herstellung von mehreren Dünnschicht- Halbleiterbauelementen möglichen Schichtaufbau zur Verwendung in dem erfindungsgemäßen Verfahren,
- Figur 2: einen weiteren Schichtaufbau zur abgewandelten Herstellung von Dünnschicht-Halbleiterbauelementen,
- Figur 3: einen dritten Schichtaufbau zur Herstellung erfindungsgemäßer Halbleiterbauelemente,
- Figur 4: ein Ausführungsbeispiel für einen anderen Schichtaufbau der Verbindungsschichten zum Einsatz in dem erfindungsgemäßen Verfahren und
- Figur 5: eine schematische Darstellung einer Abwandlung des Verfahrens zur Herstellung einer Vielzahl von verkapselten organischen Leuchtdioden.

Die Darstellungen in den Figuren sind schematisch und keinesfalls maßstäblich.

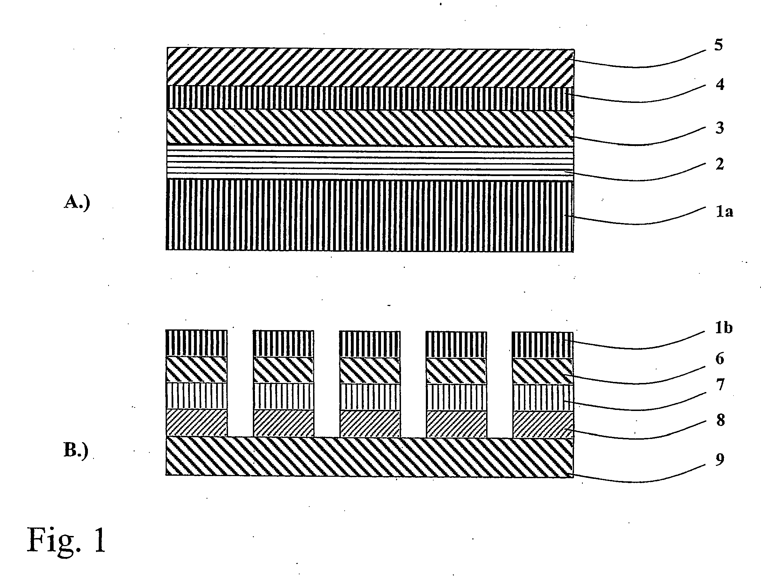

Figur 1 zeigt im Figurenteil 1A) eine vorteilhafte Ausführungsform einer Schichtabfolge auf einem Ersatzsubstrat für ein erfindungsgemäßes Verfahren. Dabei wird auf einem Träger oder Ersatzsubstrat 5, beispielsweise einem Germaniumträger, einem Keramikträger, einem Metallblech oder einem beliebigen Halbleiterwafer, zunächst eine Goldschicht 4 als Kontaktierungsschicht aufgebracht.

Der Kontaktschicht 4 folgt eine Sperrschicht 3. Derartige Sperrschichten können Legierungen aus Titan und Wolfram (TiW) oder Legierungen aus Titanwolfram und Stickstoff (TiW:N) aufweisen. Zusätzlich sind auch Sperrschichten aus Nickel oder Sperrschichten aus Nickel in Kombination mit Legierungen aus Titanwolframstickstoff möglich. Innerhalb der TiW:N-Legierungen sind die Titan- und Wolframatome meist nicht vollständig nitridiert. Die angegebenen Legierungen können unterschiedliche Konzentrationen der einzelnen Legierungspartner aufweisen. Die Konzentrationen der Legierungspartner richten sich dabei nach den Parametern des erfindungsgemäßen Verfahrens. Auch die Dicke dieser Sperrschichten ist abhängig von den Verfahrensparametern, beispielsweise von der Prozesstemperatur und der Einwirkdauer sowie des Druckes des Thermokompressionsverfahrens.

Der Sperrschicht 3 folgt eine Haftvermittlerschicht 2. Derartige Haftvermittlerschichten können Titan, eine Schichtabfolge von Titan und Platin oder auch Chromschichten aufweisen. Dieser Haftvermittlerschicht ist eine Verbindungsschicht 1a nachgeordnet. Das Verfahren sieht als Verbindungsschicht eine Goldschicht vor. Die Dicke der Goldschicht 1a kann 2000 nm betragen.

In Figurteil 1B) sind nebeneinander mehrere gleichartige Halbleiterleuchtdiodenstrukturen, von denen nur eine Struktur Bezugszeichen aufweist, auf einem Aufwachssubstrat 9 angeordnet. Das Aufwachssubstrat 9 kann ein beliebiger Halbleiterwafer, insbesondere ein Galliumarsenidwafer sein. Bei der Herstellung der LED-Strukturen auf dem Aufwachssubstrat 9 wird zunächst in einem gängigen Verfahren eine nicht näher detaillierte Leuchtdiodenstruktur 8 abgeschieden. Beispielsweise kann dies eine Leuchtdiodenstruktur auf Basis von AlGaInP (Aluminiumgalliumindiumphosphid) sein, allerdings auch jede beliebige andere denkbare Leuchtdiodenstruktur. Die Leuchtdiodenstruktur 8 weist dabei eine je nach Funktion gestaltete Halbleiterschichtenfolge auf. Diese Schichtenfolgen können aktive Schichten, dotierte Schichten, Pufferschichten und weitere Schichten umfassen.

Den einzelnen Leuchtdiodenstrukturen 8 sind Kontaktschichten 7 nachgeordnet. Erfindungsgemäße Kontaktschichten können beispielsweise aus Goldgermaniumlegierungen (Au:Ge) bestehen. Diesen Kontaktschichten 7 sind wiederum Sperrschichten 6 nachgeordnet. Die Schichtabfolgen können als Sperrschichten 6 Titanwolfram, Titanwolframnitrid, Nickelschichten oder Kombinationen dieser Materialien aufweisen. Den Sperrschichten 6 sind wiederum jeweils Verbindungsschichten 1b nachgeordnet. Diese Verbindungsschichten 1b bestehen aus Gold oder aber weisen selbst wieder eine Schichtenabfolge aus Goldschichten, Sperrschichten und weiteren Schichten, bevorzugt duktilen Metallschichten, auf. Die Dicke einer Verbindungsschicht aus Gold beträgt im Ausführungsbeispiel etwa 100 nm.

In erfindungsgemäßen Verfahren werden die Schichtfolgen der Figurenteile 1A) und 1B) mit den Seiten der Verbindungsschichten 1a, 1b gegenseitig in Kontakt gebracht und dann durch Thermokompression miteinander gefügt. Nach diesem Fügeschritt wird das Aufwachssubstrat 9 entfernt und die einzelnen Leuchtdiodenstrukturen werden, beispielsweise durch Sägen, vereinzelt. Dadurch entstehen Bauelemente, die in den Rahmen der Erfindung fallen.

Im Fügeschritt der Thermokompression werden die beiden Schichtfolgen bei hohem Druck gegeneinander verpresst. Bei der Verarbeitung von Wafern mit einem Durchmesser von 100 mm und einem cirka 50%igen Bedeckungsgrad mit Leuchtdiodenstrukturen muss dabei mindestens eine Kraft von 1.000 Newton während des Fügungsschrittes aufgewendet werden. Stabile Prozesse werden durch Kräfte zwischen 5.000 und 100.000 Newton erreicht.

Während die beiden Schichtstrukturen verpresst werden, wird die Anordnung auf eine Temperatur zwischen 200 und 500 °C erhitzt. Dabei ist in vorteilhafter Weise bei Leuchtdiodenstrukturen auf Galliumindiumnitridbasis ein Temperaturbereich von 350 °C bis 400 °C vorgesehen und bei Aluminiumgalliumindiumphosphid-Leuchtdiodenstrukturen ein Temperaturbereich zwischen 350 °C und 500 °C. Bei Verwendung eines Germanium-Trägers 5 mit anschließender Goldschicht 4 wie in Figur 1A) sollte die Prozesstemperatur auf 360 °C begrenzt werden.

Die eingesetzte Prozesstemperatur wirkt mindestens für 10 Sekunden auf die Verbindungspartner ein, besser jedoch mehr als 1 Minute. Besonders bevorzugte Ausführungsformen der Verfahren sehen vor, dass die Temperaturen zwischen 2 und 10 Minuten auf die Verbindungspartner einwirken. Obergrenzen für die Einwirkdauer der Prozesstemperatur werden durch die Anforderungen an die Durchsatzrate (Produktivität) beziehungsweise durch die Anforderungen der Halbleiterschichtstrukturen gegeben. Zu lange Einwirkzeiten können die Schichtstrukturen beeinträchtigen oder sogar zerstören.

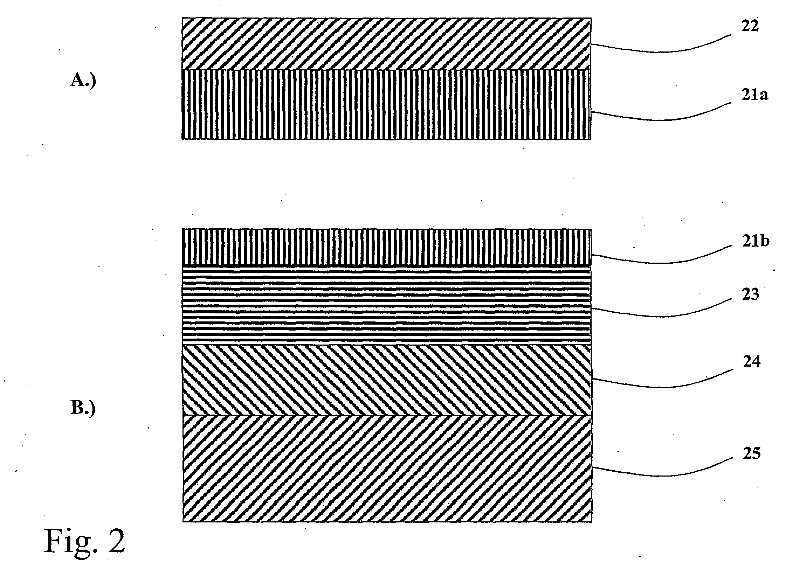

Figur 2 zeigt eine Schichtabfolge für eine Abwandlung eines Verfahrens. In Figurenteil 2A) ist einem Ersatzsubstrat 22 in Richtung auf die spätere Fügezone eine Verbindungsschicht 21a nachgeordnet. Die Ersatzsubstrate können aus Halbleiterwafern, Metallblechen oder keramischen Trägern bestehen. Besonders bevorzugt kann das Ersatzsubstrat 22 aus einem Molybdänblech bestehen. Die Verbindungsschicht 21a ist im allgemeinen eine Goldschicht, kann aber auch die Kombination aus mindestens einer Goldschicht mit weiteren Sperrschichten und weiteren metallischen Schichten bestehen.

In Figurenteil 2B) ist eine Schichtfolge für eine Abwandlung des Verfahrens zur Herstellung von Dünnfilm-Halbleiterbauelementen beziehungsweise Dünnschicht-Waferhalbzeugen dargestellt. Dabei ist einem Aufwachssubstrat 25, welches beispielsweise aus einem Halbleitermaterial, insbesondere einem Halbleiterwafer wie zum Beispiel einem Galliumarsenidwafer oder einem Saphirwafer besteht, mindestens eine nicht näher detaillierte Halbleiterstruktur 24 nachgeordnet. Die Halbleiterstruktur 24 kann eine Leuchtdiodenstruktur oder die Struktur eines beliebigen anderen Halbleiterbauelementes aufweisen. Beispielsweise kann dies eine Leuchtdiodenstruktur auf der Basis von Galliumindiumnitrid (GaInN) sein.

Dieser Halbleiterschichtenstruktur, die Dotierungsschichten, aktive Schichten, Kontaktschichten und/oder Spiegelschichten aufweist, ist eine Haftvermittlerschicht 23 aus Silber (Ag) nachgeordnet. Dieser Haftvermittlerschicht 23 wiederum ist eine Verbindungsschicht 21b nachgeordnet. Das erfindungsgemäße Verfahren bevorzugt im allgemeinen, Verbindungsschichten 21b aus Gold (Au) herzustellen, allerdings können die Verbindungsschichten auch selbst eine eigene Schichtstruktur aufweisen. So können diese Schichtstrukturen aus mehreren Metallschichten und/oder mindestens einer Sperrschicht aufgebaut sein.

Die Schichtenabfolgen der Figurenteile 2A) und 2B) werden in den Abwandlungen des Verfahrens mittels Thermokompression zueinander gefügt. Dabei wird unter hohem Druck eine Prozesstemperatur aufgewendet, welche für die Prozessdauer auf die Schichtstrukturen einwirkt. Dadurch bildet sich in dem Thermokompressionsschritt eine Fügezone aus, ohne dass es zu einer metallischen Schmelze kommt. Innerhalb dieser Fügezone kommt es insbesondere bei der Verwendung von Gold zu einer Umkristallisierung der einzelnen Metallkristallite über die ursprüngliche Fügegrenze hinweg, so dass nach der Thermokompression keine klare Fügegrenze mehr erkennbar ist. Dadurch wird eine gute sowohl thermisch als auch elektrisch leitende Verbindung gewährleistet. Zusätzlich sind die beiden Schichtfolgen fest miteinander verfügt.

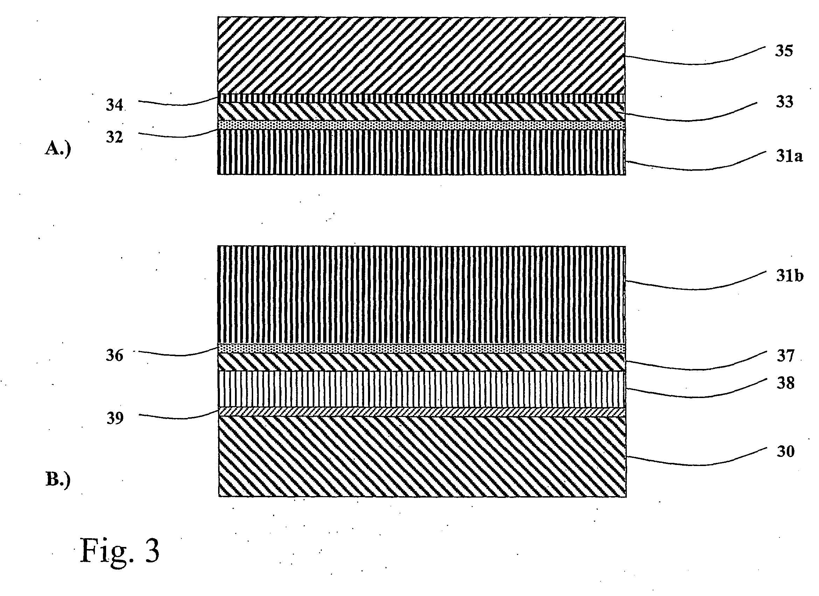

Figur 3 zeigt in den Figurenteilen 3A) und 3B) Ausführungsformen von Schichtenfolgen für den Einsatz in dem erfindungsgemäßen Fügeverfahren mittels Thermokompression. Dabei ist in Figurenteil 3A) auf einem Ersatzsubstrat 35, das beispielsweise ein Wafer aus einem Halbleitermaterial und insbesondere ein Germaniumwafer oder ein Keramikträger oder ein Metallblech sein kann, eine Zwischenschicht 34, die Aluminium aufweist, angeordnet.

Auf dieser Zwischenschicht 34 ist eine Sperrschicht 33 angeordnet, welche aus einer Titaniumwolframlegierung bestehen kann. Über dieser Sperrschicht 33 ist eine Haftvermittlungsschicht 32, die beispielsweise Platin enthält, angeordnet. Dieser Haftvermittlungsschicht 32 folgt eine Verbindungsschicht 31a, beispielsweise aus Gold.

Bei der in Figurenteil 3B) dargestellten Schichtfolge ist auf einem Aufwachssubstrat 30, beispielsweise aus Galliumarsenid (GaAs), eine beispielsweise SiNₓ enthaltende Spiegelschicht 39 angeordnet, welche eine Siliziumstickstoffverbindung aufweist. Dieser Spiegelschicht folgt eine Kontaktschicht 38, die zusätzlich Spiegelfunktionen aufweist. Diese Kontaktschicht 38 besteht oder enthält beispielsweise eine Goldzinklegierung (Au:Zn), welche eine Dicke zwischen 100 nm und 3 µm aufweisen kann. Alternativ weist die Kontaktschicht eine Legierung aus Gold und Germanium (Au:Ge) auf. Diese Kontaktschicht 38 kann auch als Kombination aus beiden Legierungen hergestellt sein und/oder zusätzlich eine Funktion als Spiegel aufweisen.

Dieser Kontaktschicht 38 ist eine Sperrschicht 37 nachgeordnet. Diese Sperrschicht besteht aus einer Titanwolframlegierung oder einer Titanwolframstickstofflegierung. Dieser Sperrschicht 37 ist eine Haftvermittlerschicht 36 nachgeordnet. Die Haftvermittlerschicht 36 besteht beispielsweise aus Titan oder aus Platin oder weist selbst eine Schichtabfolge aus Titan und Platin auf. Dieser Haftvermittlerschicht 36 ist eine Verbindungsschicht 31b aus Gold nachgeordnet.

Die Verbindungsschichten 31b und 31a bestehen aus Gold. Die Metallschichten werden dabei beispielsweise per PVD oder CVD aufgetragen, können aber auch zusätzlich Zwischenlagen aus Metallpulver innerhalb der Schichtfolge aufweisen. Zusätzlich zum Aufwachssubstrat 30 aus Galliumarsenid kann die Schicht 30 auch eine Halbleiterschichtenfolge aufweisen, wobei die Halbleiterschichtenfolge selbst wiederum funktionelle Schichten wie aktive Schichten, dotierte Schichten, Kontaktschichten, Spiegelschichten und Pufferschichten aufweisen kann.

Die Transferierung einer funktionellen Halbleiterschichtfolge auf der Basis von Galliumarsenidverbindungen auf ein Ersatzsubstrat aus Germanium ist dabei besonders vorteilhaft, da die thermische Ausdehnung von Germanium sehr gut auf die thermische Ausdehnung von Galliumarsenid angepasst ist und daher bei thermischer Beanspruchung wenig innere Verspannungen entstehen. Die Verbindungsschichten 31a und 31b werden in dem erfindungsgemäßen Verfahren durch Thermokompression miteinander verfügt.

In einer bevorzugten Ausführungsform des erfindungsgemäßen Verfahrens werden die Schichtabfolgen gemäß Figurenteilen 1A) und 1B) für 3 Minuten bei einer Prozesstemperatur von 340 °C mit einer Kraft von 6,5 kN gegeneinander verpresst. Die Schichtenabfolge der Ersatzsubstratseite weist dabei eine Goldschicht von 1000 nm auf und die Schichtenabfolge der Aufwachssubstratseite eine Schichtdicke der Goldschicht von 1200 nm. Diese beiden Goldschichten bzw. Verbindungsschichten 31a und 31b wurden in ersten Versuchen unter Anwendung der obengenannten Prozessparameter gefügt. Dabei stellte sich eine gleichmäßige Verbindung über die Gesamtfläche des Wafers mit 100 mm Durchmesser ein. Insbesondere zeigte sich bei Ultraschalluntersuchungen und in weiteren Untersuchungen keine sichtbare Fügegrenzfläche. Die Körnung der Metallschicht wurde gleichmäßig über die Grenzfläche hinweg umkristallisiert, so dass dabei keine Hohlräume, Lunker oder Poren im Fügebereich entstanden.

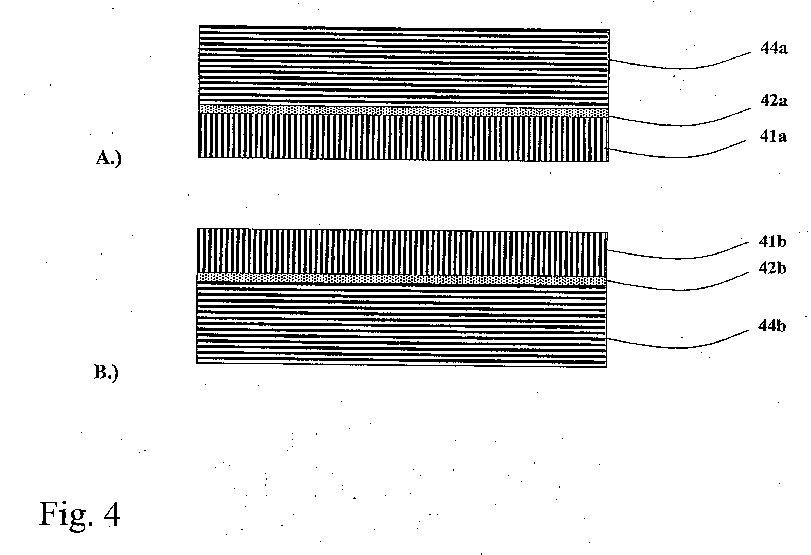

Figur 4 zeigt in den Figurenteilen 4A) und 4B) jeweils eine Schichtabfolge für Verbindungsschichten in dem erfindungsgemäßen Verfahren und entsprechenden Bauelementen. Dabei sind jeweils auf Aluminiumschichten 44a, 44b Sperrschichten 42a, 42b aus einer Titanwolframlegierung und/oder einer Titanwolframstickstofflegierung und/oder aus Nickel aufgebracht. Auf diesen Sperrschichten 42a, 42b sind jeweils Goldschichten 41a, 41b aufgebracht. Diese Verbindungsschichten werden in erfindungsgemäßen Verfahren durch Thermokompression aneinander gefügt.

Dabei wird insbesondere die Duktilität, beziehungsweise Verformbarkeit von Aluminium in Kombination mit dem inerten Verhalten von Gold ausgenutzt.

Ein derartiger Aufbau von Verbindungsschichten ermöglicht eine Thermokompression, die insbesondere frei ist von Ultraschallschweißvorgängen beziehungsweise Reibvorgängen. Werden diese Verbindungsschichten beziehungsweise Schichtabfolgen in dem erfindungsgemäßen Verfahren aneinander gefügt, so entsteht eine metallische Verbindung der innersten Schichten, der Goldschichten 41a, 41b, ohne dass ein Übergang in eine flüssige Metallschmelze erfolgt. Die Verbindungsschichten werden unter hohem Druck und einer Prozesstemperatur von bis zu 500 °C gegeneinander verpresst, wodurch es zu einer Umkristallisierung der Metallkristallite des Goldes der innersten Schicht kommt. Es entsteht eine feste und dauerhafte Verbindung.

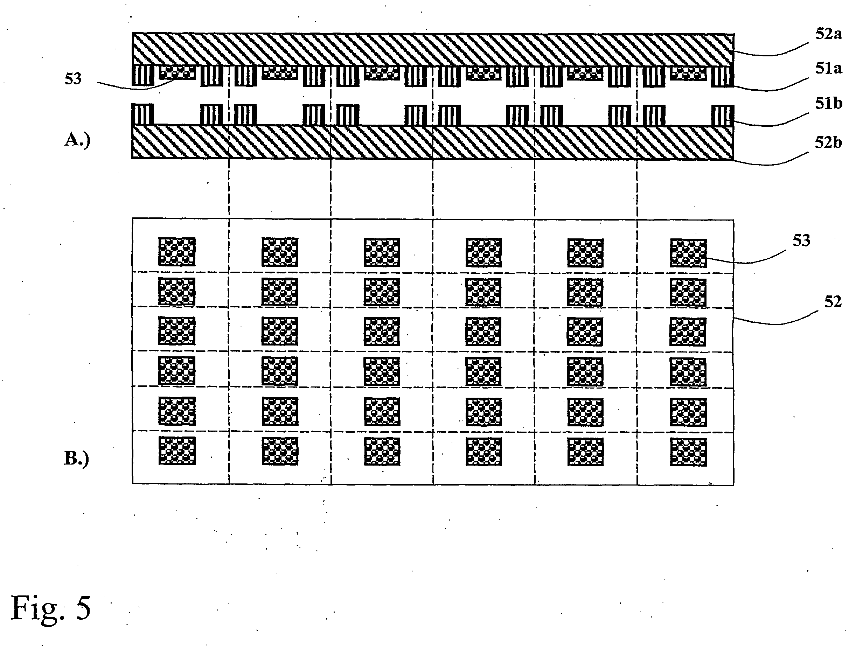

Figur 5 zeigt den Aufbau von Schichten für eine Abwandlung eines erfindungsgemäßen Verfahrens zur Herstellung beziehungsweise zur Verkapselung von organischen Leuchtdioden (OLEDs). In Figurenteil 5A) ist ein schematischer Querschnitt durch eine Anordnung vor der Thermokompression dargestellt. Figurteil 5A) zeigt insbesondere zwei Deckschichten 52a, 52b, welche durch das Thermokompressionsverfahren dauerhaft miteinander verbunden werden, wobei dadurch organische Leuchtdiodenstrukturen 53 dauerhaft verkapselt werden.

Diese Deckschichten 52a, 52b bestehen bevorzugt zumindest teilweise aus transparentem Material. Dieses weist zum Beispiel Glas oder verschiedene Polymere auf. Zusätzlich können diese Schichten auf der der Fügezone zugewandten Seite weitere funktionelle Schichten aufweisen. Dies sind beispielsweise Kontaktschichten für die Anode oder die Kathode der organischen Leuchtdiodenstruktur 53. Jede organische Leuchtdiodenstruktur 53 wird jeweils von zwei Verbindungsschichtstrukturen 51a flankiert, der selbst jeweils auf der gegenüberliegenden Schicht wieder Verbindungsschichtstrukturen 51b als Verbindungspartner gegenüber liegen.

Die Verbindungsschichtstrukturen 51a, 51b bestehen aus Gold oder aber weisen auch eine Kombination aus Schichten duktiler und inerter Metalle sowie Sperrschichten auf. Besonders vorteilhaft bestehen diese Verbindungsschichten aus Gold oder aus einer Schichtstruktur, wie sie beispielsweise in Figur 4 angegeben ist. Weiter weisen die Verbindungsschichten insbesondere zusätzliche funktionelle Schichten auf. Hierzu zählen Haftvermittlerschichten oder Isolatorschichten, welche die beiden zu verbindenden Deckschichten elektrisch voneinander isolieren. Zusätzlich können die Deckschichten 52a, 52b besonders gestaltete Lichtauskoppel- oder Lichteinkoppelflächen aufweisen. In einem erfindungsgemäßen Verfahren werden die Verbindungsschichtstrukturen 51a, 51b mittels Thermokompression miteinander verbunden. Dabei können bereits genannte Prozessparameter gewählt werden.

Figurenteil 5B) zeigt die Aufsicht auf eine solche Anordnung. Dabei sind in einem rechteckigen Raster mehrere organische Leuchtdiodenstrukturen 53 zwischen zwei transparenten Scheiben 52 angeordnet. Diese Scheiben weisen in bevorzugten Ausführungsformen Maße von 0,4 * 0,5 m² auf. Sind diese Deckschichten beziehungsweise Scheiben 52 durch das Thermokompressionsverfahren verbunden und somit die einzelnen organischen Leuchtdiodenstrukturen 53 verkapselt, können diese anschließend vereinzelt werden. In bevorzugten Ausführungsformen weisen diese vereinzelten OLEDs Maße von ca. 3 * 5 cm² auf.

Die Vereinzelung erfolgt jeweils entlang der in Figurenteil 5A) dargestellten gestrichelten Linien. Diese markieren dort den Verlauf der sogenannten "Ritzrahmen". Die Verlängerung der gestrichelten Linien hin zu Figurenteil 5A) zeigt den Verlauf der Trennlinien bzw. Ritzrahmen zwischen den Verbindungsschichtstrukturen 51a und 51b.

## Patentansprüche

1. Verfahren zur Herstellung eines Halbleiterbauelements, bei dem mehrere Schichtenfolgen, von denen jede eine thermisch verbindbare Goldschicht (1a, 1b, 21a, 21b, 31a, 31b, 41a, 41b) aufweist und von denen mindestens eine Schichtenfolge (8, 24, 30) ein Halbleitermaterial aufweist, mittels einer durch Thermokompression gebildeten Fügeschicht (1, 21, 31, 41) miteinander verbunden werden, wobei die Goldschichten (1a, 1b, 21a, 21b, 31a, 31b, 41a, 41b) zu der gemeinsamen Fügeschicht verbunden werden und das Verbinden bei einer Temperatur zwischen einschließlich 200 °C und 500 °C und bei einem Druck zwischen einschließlich 0,1 MPa und 20 MPa erfolgt,
wobei das Halbleiterbauelement dazu eingerichtet ist, Strahlung zu emittieren und wobei das Halbleitermaterial eine epitaktisch strukturierte Schichtenfolge (8, 24, 30) aufweist, welche überwiegend aus III-V-Halbleitermaterialien besteht,
**dadurch gekennzeichnet, dass**
in den verbundenen Schichtenfolgen, von der Fügeschicht (1, 21, 31, 41) aus gesehen, der Fügeschicht jeweils eine Sperrschicht (33, 42) aus einer TiW-Legierung, einer TiWN-Legierung oder aus Nickel und der Sperrschicht (33, 42) jeweils eine Aluminiumschicht (34, 44) als duktile Schicht nachgeordnet ist.

2. Verfahren nach Anspruch 1,
**dadurch gekennzeichnet, dass**
das Halbleitermaterial einen Dünnfilmchip aufweist.

3. Verfahren nach dem vorangegangenen Anspruch,
**dadurch gekennzeichnet, dass**
das Halbleitermaterial eine Dünnschichtleuchtdiode aufweist.

4. Verfahren nach einem der vorangegangenen Ansprüche,
**dadurch gekennzeichnet, dass**
eine der Schichtenfolgen ein Ersatzsubstrat (5, 22, 35) aufweist, wobei das Ersatzsubstrat (5, 22, 35) von einem Epitaxiesubstrat für das Halbleitermaterial verschieden ist.

5. Verfahren nach Anspruch 4,
**dadurch gekennzeichnet, dass**
die Goldschichten (1a, 1b, 21a, 21b, 31a, 31b, 41a, 41b) unterschiedliche Dicken aufweisen.

6. Verfahren nach Anspruch 4 oder 5,
**dadurch gekennzeichnet, dass**
zwischen der Goldschicht (1a, 21a, 31a, 41a) der Schichtenfolge mit dem Halbleitermaterial und dem Halbleitermaterial sowie zwischen der Goldschicht (1b, 21b, 31b, 41b) der Schichtenfolge mit dem Ersatzsubstrat (5, 22, 35) und dem Ersatzsubstrat (5, 22, 35) jeweils mindestens eine funktionelle Schicht aus der Gruppe, die aus Haftvermittlerschicht (2, 32, 36), Spiegelschicht (38, 39), Kontaktschicht (4, 7, 38) und Pufferschicht besteht, angeordnet ist.

7. Verfahren nach Anspruch 6,
**dadurch gekennzeichnet, dass**
bei dem Verbinden die Schichtenfolge mit dem Ersatzsubstrat (5, 22, 35) die folgenden Schichten in der angegebenen Reihenfolge aufweist:
- das Ersatzsubstrat (5, 22, 35),
- die Aluminiumschicht (34, 44),
- die Sperrschicht (33, 42),
- die Haftvermittlerschicht (32), und
- die Goldschicht (31a),
wobei die Schichtenfolge mit dem Halbleitermaterial bei dem Verbinden die folgenden Schichten in der angegebenen Reihenfolge aufweist:
- das Epitaxiesubstrat (30),
- die Spiegelschicht (39),
- die Kontaktschicht (38),
- die Sperrschicht (37),
- die Haftvermittlerschicht (36), und
- die Goldschicht (31b).

8. Verfahren nach einem der Ansprüche 1 bis 5,
**dadurch gekennzeichnet, dass**
die Aluminiumschichten (34, 44) jeweils unmittelbar auf die Sperrschichten (33, 42) und die Sperrschichten (33, 42) jeweils unmittelbar auf die Goldschichten (1a, 1b, 21a, 21b, 31a, 31b, 41a, 41b) folgen.

9. Verfahren nach einem der vorangegangenen Ansprüche,
**dadurch gekennzeichnet, dass**
das Thermokompressionsverfahren frei von folgenden Verfahrensschritten ist: Reibbewegungen, Ultraschallschweißvorgänge.

## Claims

1. Method for the manufacture of a semi-conductor element, wherein several layer sequences, of which each layer sequence comprises a thermally connectable gold layer (1a, 1b, 21a, 21b, 31a, 31b, 41a, 41b) and of which at least one layer sequence (8, 24, 30) comprises a semi-conductor are connected to each other by means of a joining layer (1, 21, 31, 41) formed by thermo-compression, wherein the gold layers (1a, 1b, 21a, 21b, 31a, 31b, 41a, 41b) are connected to form the common joining layer and the connecting process is performed at a temperature between 200 °C and 500 °C inclusive and at a pressure between 0,1 MPa and 20 MPa inclusive,
wherein the semi-conductor element is adapted
to emit radiation and wherein the semi-conductor material comprises an epitaxially structured layer sequence (8, 24, 30) which consists predominantly of III-V semi-conductor materials, **characterised in that**
in the connected layer sequences, as seen from the joining layer (1, 21, 31, 41), a TiW alloy, a TiWN alloy or nickel barrier layer (33, 42) is disposed in each case downstream of the joining layer and an aluminium layer (34, 44) is disposed as a ductile layer in each case downstream of the barrier layer (33, 42).

2. Method as claimed in claim 1,
**characterised in that**
the semi-conductor material comprises a thin film chip.

3. Method as claimed in the preceding claim,
**characterised in that**
the semi-conductor material comprises a thin layer light-emitting diode.

4. Method as claimed in any one of the preceding claims, **characterised in that**
one of the layer sequences comprises a replacement substrate (5, 22, 35), wherein the replacement substrate (5, 22, 35) is different from an epitaxy substrate for the semi-conductor material.

5. Method as claimed in claim 4,
**characterised in that**
the gold layers (1a, 1b, 21a, 21b, 31a, 31b, 41a, 41b) have different thicknesses.

6. Method as claimed in Claim 4 or 5,
**characterised in that**
in each case at least one functional layer of the group which consists of an adhesion-promoting layer (2, 32, 36), a reflective layer (38, 39), a contact layer (4, 7, 38) and a buffer layer is disposed between the gold layer (1a, 21a, 31a, 41a) of the layer sequence with the semi-conductor material and the semi-conductor material and between the gold layer (1b, 21b, 31b, 41b) of the layer sequence with the replacement substrate (5, 22, 35) and the replacement substrate (5, 22, 35).

7. Method as claimed in claim 6,
**characterised in that**
during connection the layer sequence have the replacement substrate (5, 22, 35) comprises the following layers in the specified sequence:
- the replacement substrate (5, 22, 35),
- the aluminium layer (34, 44),
- the barrier layer (33, 42),
- the adhesion-promoting layer (32) and
- the gold layer (31a),
wherein, during connection, the layer sequence having the semi-conductor material comprises the following layers in the specified sequence:
- the epitaxy substrate (30),
- the reflective layer (39),
- the contact layer (38),
- the barrier layer (37),
- the adhesion-promoting layer (36) and
- the gold layer (31b).

8. Method as claimed in any one of claims 1 to 5,
**characterised in that**
the aluminium layers (34, 44) in each case directly follow on the barrier layers (33, 42) and in each as the barrier layers (33, 42) directly follow on the gold layers (1a, 1b, 21a, 21b, 31a, 31b, 41a, 41b).

9. Method as claimed in any one of the preceding claims,
**characterised in that**
the thermo-compression method does not include the following method steps: frictional movements, ultra-sonic welding processes.

## Revendications

1. Procédé permettant de fabriquer un composant semi-conducteur, dans lequel plusieurs successions de couches, dont chacune présente une couche d'or connectable thermiquement (1a, 1b, 21a, 21b, 31a, 31b, 41a, 41b) et dont au moins une succession de couches (8, 24, 30) présente un matériau semi-conducteur, sont raccordées entre elles au moyen d'une couche de jonction (1, 21, 31, 41) formée par thermocompression, les couche d'or (1a, 1b, 21a, 21b, 31a, 31b, 41a, 41b) étant reliées à la couche de jonction commune et la liaison étant réalisée à une température comprise entre y compris 200°C et 500°C et à une pression comprise entre y compris 0,1 MPa et 20 MPa,
le composant semi-conducteur étant configuré pour émettre un rayonnement et le matériau semi-conducteur présentant une succession de couches (8, 24, 30) à structure épitactique, laquelle est principalement constituée de matériaux semiconducteurs du groupe III-V,
**caractérisé en ce que**
dans les successions de couches reliées, vues depuis la couche de jonction (1, 21, 31, 41), une couche de barrage (33, 42) constituée d'un alliage de TiW, d'un alliage de TiWN, ou constituée de nickel est respectivement disposée en aval de la couche de jonction, et **en ce qu'**une couche d'aluminium (34, 44) est respectivement disposée en aval de la couche de barrage (33, 42) en tant que couche ductile.

2. Procédé selon la revendication 1,
**caractérisé en ce que**
le matériau semi-conducteur présente une puce à film mince.

3. Procédé selon la revendication précédente,
**caractérisé en ce que**
le matériau semi-conducteur présente une diode luminescente à couche mince.

4. Procédé selon l'une quelconque des revendications précédentes,
**caractérisé en ce que**
l'une des successions de couches présente un substrat de substitution (5, 22, 35), le substrat de substitution (5, 22, 35) étant différent d'un substrat d'épitaxie pour le matériau semi-conducteur.

5. Procédé selon la revendication 4,
**caractérisé en ce que**
les couches d'or (1a, 1b, 21a, 21b, 31a, 31b, 41a, 41b) présentent différentes épaisseurs.

6. Procédé selon la revendication 4 ou 5,
**caractérisé en ce qu'**
au moins une couche fonctionnelle, provenant du groupe constitué de la couche de l'agent adhésif (2, 32, 36), de la couche de réflexion (38, 39), de la couche de contact (4, 7, 38) et de la couche tampon, est respectivement disposée entre la couche d'or (1a, 21a, 31a, 41a) de la succession de couches comprenant le matériau semi-conducteur et le matériau semi-conducteur ainsi qu'entre la couche d'or (1b, 21b, 31b, 41b) de la succession de couches comprenant le substrat de substitution (5, 22, 35) et le substrat de substitution (5, 22, 35).

7. Procédé selon la revendication 6,
**caractérisé en ce que**
lors de la liaison, la succession de couches comprenant le substrat de substitution (5, 22, 35) présente les couches suivantes dans l'ordre indiqué :
- le substrat de substitution (5, 22, 35),
- la couche d'aluminium (34, 44),
- la couche de barrage (33, 42),
- la couche d'agent adhésif (32), et
- la couche d'or (31a),
la succession de couches comprenant le matériau semi-conducteur présentant, lors de la liaison, les couches suivantes dans l'ordre indiqué :
- le substrat d'épitaxie (30),
- la couche de réflexion (39),
- la couche de contact (38),
- la couche de barrage (37),
- la couche d'agent adhésif (36) et
- la couche d'or (31b).

8. Procédé selon l'une quelconque des revendications 1 à 5,
**caractérisé en ce que**
les couches d'aluminium (34, 44) succèdent chacune directement aux couches de barrage (33, 42) et **en ce que** les couches de barrage (33, 42) succèdent chacune directement aux couches d'or (1a, 1b, 21a, 21b, 31a, 31b, 41a, 41b).

9. Procédé selon l'une quelconque des revendications précédentes,
**caractérisé en ce que**
le procédé de thermocompression est exempt des étapes de procédé suivantes: mouvements de friction, opérations de soudage par ultrasons.
